# EUROPEAN PATENT APPLICATION

(11) **EP 4 750 303 A1**
(43) Date of publication of application: **27.05.2026**
(21) Application number: 25217350.5
(22) Date of filing: 20.11.2025
(51) Int. Cl.: H10P 14/20, H10P 14/24, H10P 14/26

(54) **SEMICONDUCTOR DEVICE, ELECTRONIC DEVICE, AND SYSTEM**

(30) Priority: 22.11.2024 JP 2024204267
(71) Applicant: Patentix Inc., Kusatsu-shi, Shiga 5258577 (JP)
(72) Inventor: Matsuda, Shinpei, Shiga, 5258577 (JP); Shimizu, Yuri, Shiga, 5258577 (JP); Takahashi, Isao, Shiga, 5258577 (JP); Kaneko, Kentaro, Shiga, 5258577 (JP)
(74) Representative: advotec.

(57) **Abstract**

To provide a semiconductor device, an electronic device, and a system that are useful in a power device or the like and have superior electrical characteristics. A semiconductor device including a laminated structure in which a second semiconductor layer having a same crystal structure as a first semiconductor layer constituted of a crystalline oxide containing germanium or a mixed crystal of germanium as a main component is laminated directly or via another layer on the first semiconductor layer, the semiconductor device further including a Schottky electrode forming a Schottky junction with the second semiconductor layer and an ohmic electrode forming an ohmic junction with the first semiconductor layer, the semiconductor device being used and applied to, for example, a power device.

## Description

### BACKGROUND OF THE INVENTION

### Field of the Invention

The present invention relates to a semiconductor device, an electronic device, and a system thereof that are useful as a power device or the like.

### Description of the Related Art

In recent years, rutile-structured germanium dioxide (r-GeO₂) has been attracting attention as a promising ultra-wide bandgap (UWBG) semiconductor for future power electronic devices. Given that r-GeO₂ has a band gap of 4.68 eV, enables the realization of n-type and p-type semiconductors, and can also be produced inexpensively, r-GeO₂ is considered a promising candidate for next-generation semiconductor devices.

A laminated structure in which an r-GeO₂ crystal film is laminated on an r-TiO₂ (001) substrate is considered in: H. Takane, K. Kaneko., "Establishment of a growth route of crystallized rutile GeO2 thin film (≥1 µm/h) and its structural properties", Applied Physics Letters Vol.119, pp.062104 (1-6) (2021), International Publication No. WO 2023/008454, International Publication No. WO 2023/008453, and International Publication No. WO 2023/008452. However, H. Takane, K. Kaneko., Erratum: "Establishment of a growth route of crystallized rutile GeO2 thin film (≥1 µm/h) and its structural properties", Applied Physics Letters Vol.120, 099903 (1-3) (2022) was submitted as an Erratum after a review of H. Takane, K. Kaneko., "Establishment of a growth route of crystallized rutile GeO2 thin film (≥1 µm/h) and its structural properties", Applied Physics Letters Vol.119, pp.062104 (1-6) (2021), whereby it was found that the crystal grains (abnormal grains) described in H. Takane, K. Kaneko., "Establishment of a growth route of crystallized rutile GeO2 thin film (≥1 µm/h) and its structural properties", Applied Physics Letters Vol.119, pp.062104 (1-6) (2021) and International Publication No. WO 2023/008454 were rutile-type germanium dioxide crystals while other parts were an amorphous phase. In other words, only an amorphous phase was formed in most parts, and even when a crystalline phase was formed, crystal grains were only formed in some parts. Therefore, a method that would enable the manufacture of crystalline films with superior crystallinity that could be electrically controlled was eagerly anticipated.

In addition, H. Takane, et al., "Band-gap engineering of rutile-structured SnO2-GeO2-SiO2 alloy system", PHYSICAL REVIEW MATERIALS 6, 084604 (2022) considers the fabrication of an alloy thin film of r-(Ge, Sn)O₂ by mixing readily crystallizable tin dioxide (r-SnO₂) with r-GeO₂, and confirms n-type conductivity. However, since the band gap of r-SnO₂ is 3.7 eV which is smaller than that of r-GeO₂, the characteristics of r-GeO₂ cannot be utilized with a thin alloy film of r-(Ge, Sn)O₂, and it is also difficult to control the composition of Ge and Sn.

Furthermore, H. Takane, et al., "Rutile-type Gex Sn1-x O2 alloy layers latticematched to TiO2 substrates for device applications", Applied Physics Express 17, 011008 (2024) describes the fabrication of an alloy thin film of r-(Ge, Sn)O₂ by mixing readily crystallizable tin dioxide (r-SnO₂) with r-GeO₂, and the prototyping of a Schottky barrier diode (SBD).

However, an SBD using an alloy thin film of r-(Ge, Sn)O₂ is difficult to control in terms of composition as well as electrical characteristics, and problems such as deterioration of semiconductor characteristics make it difficult to realize industrially useful semiconductor devices. Therefore, a method to obtain a semiconductor device using an industrially-useful r-GeO₂ single crystal film was eagerly anticipated.

An object of the present invention is to provide a GeO₂ semiconductor device with superior electrical characteristics.

### SUMMARY OF THE INVENTION

As a result of intensive studies conducted in order to achieve the object described above, the present inventors have: newly developed a mist CVD apparatus using a guide barrier; succeeded in creating, using the mist CVD apparatus using a guide barrier, a semiconductor device including a laminated structure in which a second semiconductor layer having a same crystal structure as a first semiconductor layer including a crystalline oxide containing germanium or a mixed crystal of germanium as a main component is laminated directly or via another layer on the first semiconductor layer, the semiconductor device further including a Schottky electrode forming a Schottky junction with the second semiconductor layer and an ohmic electrode forming an ohmic junction with the first semiconductor layer; discovered that the obtained semiconductor device has superior crystallinity, superior electrical characteristics, and the like; and found that such a semiconductor device is capable of single-handedly solving all of the conventional problems described above.

In addition, after making the discoveries described above, the present inventors conducted further studies and completed the present invention.

Specifically, the present invention is related to the following inventions.
[1] A semiconductor device comprising a laminated structure in which a second semiconductor layer having a same crystal structure as a first semiconductor layer including a crystalline oxide containing germanium or a mixed crystal of germanium as a main component is laminated directly or via another layer on the first semiconductor layer, the semiconductor device further comprising
   a Schottky electrode forming a Schottky junction with the second semiconductor layer and an ohmic electrode forming an ohmic junction with the first semiconductor layer.
[2] The semiconductor device according to [1], wherein the second semiconductor layer is including a crystalline oxide containing germanium or a mixed crystal of germanium as a main component.
[3] The semiconductor device according to [1], wherein the first semiconductor layer has a rutile structure.
[4] The semiconductor device according to [1], wherein the first semiconductor layer contains a dopant.
[5] The semiconductor device according to [4], wherein the dopant contains an element from Group 15 of the periodic table.
[6] The semiconductor device according to [1], wherein the crystalline oxide contains germanium dioxide as a main component.
[7] The semiconductor device according to [1], wherein a film thickness of the first semiconductor layer is 500 nm or more.
[8] The semiconductor device according to [1], wherein a film thickness of the second semiconductor layer is 1.0 µm or more.
[9] The semiconductor device according to [1], wherein an area of the first semiconductor layer is 100 mm² or more.
[10] The semiconductor device according to [1], wherein a carrier concentration of the first semiconductor layer is 1 × 10¹⁹/cm³ or higher.
[11] The semiconductor device according to [1], wherein a carrier concentration of the second semiconductor layer is 1 × 10¹⁸/cm³ or lower.
[12] The semiconductor device according to [1], wherein the ohmic electrode contains one or two metallic elements selected from Groups 4 to 13 of the periodic table.
[13] The semiconductor device according to [1], wherein the Schottky electrode contains one or two metallic elements selected from Groups 4 to 13 of the periodic table.
[14] The semiconductor device according to [1], which is a power device.
[15] The semiconductor device according to [1], which is a Schottky barrier diode (SBD).
[16] An electronic device comprising a semiconductor device, wherein the semiconductor device is the semiconductor device according to [1].
[17] A system comprising an electronic device, wherein the electronic device is the electronic device according to [16].

The semiconductor device according to the present invention is a GeO₂ semiconductor device with superior electrical characteristics.

### BRIEF DESCRIPTION OF THE DRAWINGS

FIG. 1 is an example of a schematic configuration diagram of a film deposition apparatus suitably used in the present invention;
FIG. 2 is a diagram schematically showing an atomization apparatus suitably used in the present invention;
FIG. 3 is a diagram showing a result of 2θ/ω in an XRD diffraction result according to "1. Formation of n⁺ semiconductor layer" in Example 1;
FIG. 4 is a diagram of a result of an ω scan in a rocking curve measurement of XRD diffraction according to Example 1;
FIG. 5 is a diagram schematically showing a suitable example of a Schottky barrier diode (SBD) according to the present invention;
FIG. 6 is a diagram schematically showing a suitable example of a Schottky barrier diode (SBD) according to the present invention;
FIG. 7 is a sectional schematic view showing a suitable example of a Schottky barrier diode (SBD) according to Example 1;
FIG. 8 is a diagram showing a surface image of a sample in which an electrode is formed on a crystal film according to Example 1;
FIG. 9 is a diagram schematically showing a sectional view from the side of an atomization apparatus suitably used in the present invention;
FIG. 10 is a diagram showing a result of an IV measurement according to Example 1, in which an axis of ordinate represents current (A) and an axis of abscissa represents voltage (V);
FIG. 11 is a table showing a relationship between carrier concentration derived from a result of a CV measurement according to Example 1 and depth, in which an axis of ordinate represents carrier concentration and an axis of abscissa represents depth;
FIG. 12 is a diagram showing a result of 2θ/ω in an XRD diffraction result according to "2. Formation of n⁻ semiconductor layer" in Example 1;
FIG. 13 is a diagram showing a result of ohmic characteristics of an SBD with a pseudo-vertical structure obtained from Example 1 when implemented by an IV measurement;
FIG. 14 is a diagram showing a result of a TLM measurement of an SBD with the pseudo-vertical structure obtained from Example 1;
FIG. 15 is a diagram showing a result of secondary ion mass spectrometry (SIMS) of an SBD with the pseudo-vertical structure obtained from Example 1;
FIG. 16 is a diagram schematically showing a suitable example of a metal-semiconductor field-effect transistor (MESFET) according to the present invention;
FIG. 17 is a diagram schematically showing a suitable example of a power supply system;
FIG. 18 is a diagram schematically showing a suitable example of a system apparatus; and
FIG. 19 is a diagram schematically showing a suitable example of a power supply circuit diagram of a power supply apparatus.

### DETAILED DESCRIPTION OF THE INVENTION

A semiconductor device according to the present invention is a semiconductor device including a laminated structure in which a second semiconductor layer having a same crystal structure as a first semiconductor layer including a crystalline oxide containing germanium or a mixed crystal of germanium as a main component is laminated directly or via another layer on the first semiconductor layer, the semiconductor device further including a Schottky electrode forming a Schottky junction with the second semiconductor layer and an ohmic electrode forming an ohmic junction with the first semiconductor layer. In the present specification, "film" can be read as "layer". A "laminated structure" is a structure including one or more crystalline layers and may include a layer other than a crystalline layer (for example, an amorphous layer). In addition, while the crystalline layer is preferably a single crystalline layer, the crystalline layer may be a polycrystalline layer.

In the present invention, the carrier density of the first semiconductor layer is preferably 5 × 10¹⁸cm⁻³ or more,and more higher and more preferably 1 × 10¹⁹cm⁻³ or more. The carrier density of the second semiconductor layer is preferably 1 × 10¹⁸cm⁻³ or lower and more preferably 5 × 10¹⁷cm⁻³ or lower. According to such preferable ranges, semiconductor characteristics can be made more superior and more favorable electrical characteristics can be obtained.

A "main component" in the present invention refers to the fact that a content of germanium in the crystalline oxide is 50at% or more as a composition ratio of the crystalline oxide. In an embodiment of the present invention, the content of germanium in the crystalline oxide is preferably 70at% or more and more preferably 90at% or more as a composition ratio of the crystalline oxide. Furthermore, while the crystalline oxide according to the present invention is not particularly limited as long as it does not hinder the object of the present invention, the crystalline oxide preferably contains germanium dioxide as a main component. According to such a preferable range, an interface can be made more favorable and both electrical characteristics and semiconductor characteristics can be made more superior.
In addition, the metal oxide film may include metals other than germanium. Examples of the other metals include one or two or more metals selected from metals other than germanium of Group 14 of the periodic table (such as tin or silicon) or metals of Group 4 of the periodic table (such as titanium, zirconium, or hafnium). The atomic ratio of germanium in the metal oxide film is preferably 0.5 or higher. In addition, while the crystal structure of the metal oxide film is not particularly limited and may be a rutile crystal structure which is tetragonal, an α-quartz structure which is trigonal, a CaCl₂ crystal structure which is orthorhombic, an α-PbO₂ crystal structure, or a pyrite crystal structure which is tetragonal, the crystal structure according to the present invention is preferably a rutile structure which is tetragonal. Furthermore, while the semiconductor layer is not particularly limited as long as it does not hinder the object of the present invention, in the present invention, the semiconductor layer preferably uses a crystalline oxide having a rutile structure as a constituent material. According to such a preferable range, a crystal film with more favorable semiconductor characteristics can be realized.

In addition, while the crystal structure or the like of the crystalline oxide is not particularly limited and may be a rutile crystal structure which is tetragonal, an α-quartz structure which is trigonal, a CaCl₂ crystal structure which is orthorhombic, an α-PbO₂ crystal structure, or a pyrite crystal structure which is tetragonal, the crystalline oxide according to the present invention preferably has a rutile structure which is tetragonal. According to such a preferable range, semiconductor characteristics can be made more favorable.

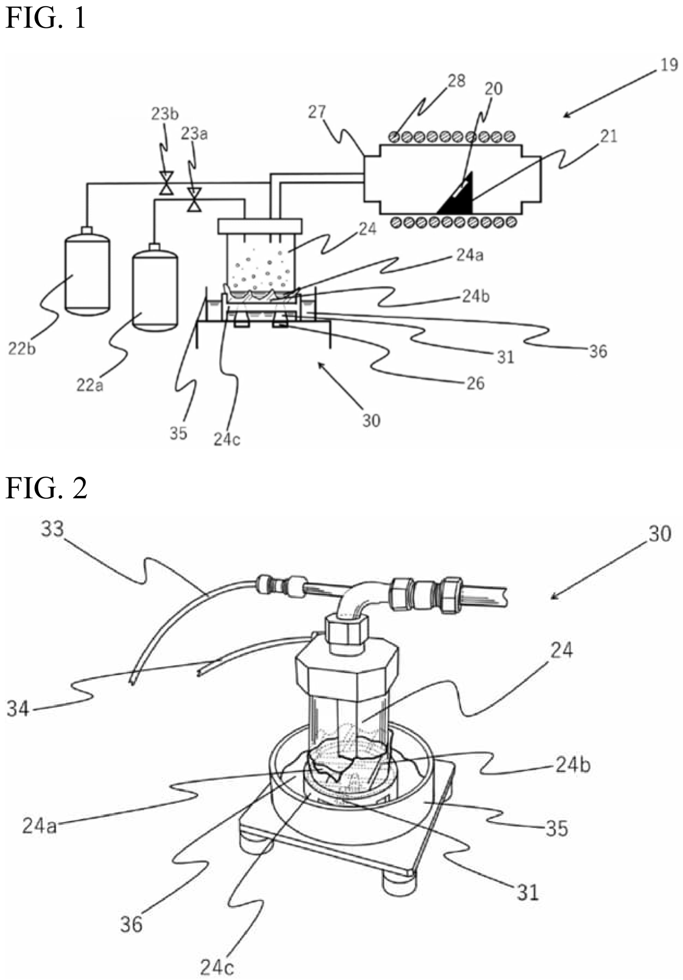

Doping of the preferable laminated structure described above can be more readily controlled using, for example, the film deposition apparatus shown in FIG. 1. In the present invention, the semiconductor layer more preferably has an area of 100 mm² or more. In addition, the semiconductor layer is preferably a single crystalline film. According to such preferable ranges, the semiconductor layer can achieve a more preferable breakdown voltage and more superior electrical characteristics. Furthermore, while a film thickness of the semiconductor layer is not particularly limited as long as it does not hinder the object of the present invention, in the present invention, the film thickness of the semiconductor layer is preferably 500 nm or more and the film thickness of the second semiconductor layer is 1.0 µm or more. Adopting such a preferable film thickness or area enables more superior electrical characteristics such as breakdown voltage characteristics to be imparted to the semiconductor device when the laminated structure is applied to the semiconductor device.

The semiconductor layer according to the present invention favorably contains a dopant, and while the dopant is not particularly limited as long as it does not hinder the object of the present invention, examples thereof include elements of Group 15 of the periodic table, elements of Group 13 of the periodic table, and the like. In the present invention, the dopant preferably contains an element of Group 15 of the periodic table. Examples of elements of Group 15 of the periodic table include nitrogen (N), phosphorus (P), arsenic (As), antimony (Sb), and bismuth (Bi). Examples of elements of Group 13 of the periodic table include boron (B), aluminum (Al), gallium (Ga), and indium (In). According to such preferable ranges, more favorable electrical characteristics can be obtained and manufacturing can be facilitated.

In addition, the ohmic electrode is not particularly limited as long as it contains one or two metallic elements selected from Groups 4 to 13 of the periodic table and may be a single metal layer or comprising two or more metal layers. Laminating means of the metal layers is not particularly limited and, for example, known means such as vapor deposition or sputtering may be used. In addition, the metal that constitutes the ohmic electrode may be an alloy. The ohmic electrode preferably contains one or two metallic elements selected from Groups 4 to 13 of the periodic table. Examples of the one or two or more metallic elements belonging to any of Groups 4 to 13 of the periodic table include a metallic element of Group 4 of the periodic table, a metallic element of Group 5 of the periodic table, a metallic element of Group 6 of the periodic table, a metallic element of Group 7 of the periodic table, a metallic element of Group 8 of the periodic table, a metallic element of Group 9 of the periodic table, a metallic element of Group 10 of the periodic table, a metallic element of Group 11 of the periodic table, a metallic element of Group 12 of the periodic table, a metallic element of Group 13 of the periodic table, and alloys thereof. Examples of the one or two or more metallic elements belonging to any of Groups 4 to 13 of the periodic table include a metallic element of Group 4 of the periodic table, a metallic element of Group 5 of the periodic table, a metallic element of Group 6 of the periodic table, a metallic element of Group 7 of the periodic table, a metallic element of Group 8 of the periodic table, a metallic element of Group 9 of the periodic table, a metallic element of Group 10 of the periodic table, a metallic element of Group 11 of the periodic table, a metallic element of Group 12 of the periodic table, a metallic element of Group 13 of the periodic table, and alloys thereof. While examples of metals of Group 4 of the periodic table include titanium (Ti), zirconium (Zr), hafnium (Hf), and alloys thereof, in the present invention, titanium is preferably contained. Examples of metals of Group 5 of the periodic table include vanadium (V), niobium (Nb), tantalum (Ta), and alloys thereof. Examples of metals of Group 6 of the periodic table include chromium (Cr), molybdenum (Mo), tungsten (W), and alloys thereof, and examples of metals of Group 7 of the periodic table include manganese (Mn), technetium (Tc), rhenium (Re), and alloys thereof. Examples of metals of Group 8 of the periodic table include iron (Fe), ruthenium (Ru), osmium (Os), and alloys thereof. Examples of metals of Group 9 of the periodic table include cobalt (Co), rhodium (Rh), iridium (Ir), and alloys thereof. Examples of metals of Group 10 of the periodic table include nickel (Ni), palladium (Pd), platinum (Pt), and alloys thereof. While examples of metals of Group 11 of the periodic table include copper (Cu), silver (Ag), gold (Au), and alloys thereof, in the present invention, gold (Au) is preferably contained. Examples of metals of Group 12 of the periodic table include zinc (Zn), cadmium (Cd), and alloys thereof. Examples of elements of Group 13 of the periodic table include aluminum (Al), gallium (Ga), indium (In), and alloys thereof. In addition, in the present invention, the ohmic electrode preferably includes Ti and/or Au and more preferably includes Ti and Au. According to such preferable ranges, semiconductor characteristics (for example, durability, dielectric breakdown voltage, breakdown voltage, on-resistance, and stability) of the first semiconductor layer can be made more favorable and ohmic characteristics can also be made more favorable.

The Schottky electrode is not particularly limited as long as it contains one or two metallic elements selected from Groups 4 to 13 of the periodic table and may be a single metal layer or comprising two or more metal layers. Laminating means of the metal layers is not particularly limited and, for example, known means such as vapor deposition or sputtering may be used. In addition, the metal that constitutes the Schottky electrode may be an alloy. The Schottky electrode preferably contains one or two metallic elements selected from Groups 4 to 13 of the periodic table. Examples of the one or two or more metallic elements belonging to any of Groups 4 to 13 of the periodic table include a metallic element of Group 4 of the periodic table, a metallic element of Group 5 of the periodic table, a metallic element of Group 6 of the periodic table, a metallic element of Group 7 of the periodic table, a metallic element of Group 8 of the periodic table, a metallic element of Group 9 of the periodic table, a metallic element of Group 10 of the periodic table, a metallic element of Group 11 of the periodic table, a metallic element of Group 12 of the periodic table, a metallic element of Group 13 of the periodic table, and alloys thereof. Examples of metals of Group 4 of the periodic table include titanium (Ti), zirconium (Zr), hafnium (Hf), and alloys thereof. Examples of metals of Group 5 of the periodic table include vanadium (V), niobium (Nb), tantalum (Ta), and alloys thereof. Examples of metals of Group 6 of the periodic table include chromium (Cr), molybdenum (Mo), tungsten (W), and alloys thereof, and examples of metals of Group 7 of the periodic table include manganese (Mn), technetium (Tc), rhenium (Re), and alloys thereof. Examples of metals of Group 8 of the periodic table include iron (Fe), ruthenium(Ru), osmium (Os), and alloys thereof. Examples of metals of Group 9 of the periodic table include cobalt (Co), rhodium (Rh), iridium (Ir), and alloys thereof. While examples of metals of Group 10 of the periodic table include nickel (Ni), palladium (Pd), platinum (Pt), and alloys thereof, in the present invention, Ni or Pt is preferably contained. Examples of metals of Group 11 of the periodic table include copper (Cu), silver (Ag), gold (Au), and alloys thereof.

Examples of metals of Group 12 of the periodic table include zinc (Zn), cadmium (Cd), and alloys thereof. Examples of elements of Group 13 of the periodic table include aluminum (Al), gallium (Ga), indium (In), and alloys thereof. In addition, in the present invention, the Schottky electrode preferably includes Au and/or Ni and more preferably includes Au and Ni. According to such preferable ranges, semiconductor characteristics (for example, durability, dielectric breakdown voltage, breakdown voltage, on-resistance, and stability) of the second semiconductor layer can be made more favorable and Schottky characteristics can also be made more favorable.

In the present invention, while the first semiconductor layer may be directly formed on an underlying substrate, another layer such as a layer that differs from the first semiconductor layer (for example, an n-type semiconductor layer, an n⁺ semiconductor layer, or an n⁻semiconductor layer), an insulator layer (including a semi-insulator layer), or a buffer layer may be laminated on the underlying substrate and the first semiconductor layer may be formed on the other layer. In particular, a buffer layer can be suitably used in order to mitigate a lattice constant difference between the first semiconductor layer and the underlying substrate. Examples of a constituent material of the buffer layer include SnO₂, TiO₂, VO₂, MnO₂, RuO₂, CsO₂, IrO₂, GeO₂, CuO₂, PbO₂, AgO₂, CrO₂, SiO₂, SiC, GaN, Pt, and mixed crystals thereof.

The semiconductor layer can be more readily obtained by forming a semiconductor layer including a crystalline oxide containing germanium or a mixed crystal of germanium as a main component using, for example, the film deposition apparatus shown in FIG. 1. In addition, the film deposition apparatus also enables doping to be performed in an appropriate manner. The doped crystal can be suitably used as a semiconductor film or a semiconductor layer, and an n-type dopant or a p-type dopant can be applied to conventional doping means in an oxide semiconductor. Examples of the n-type dopant include antimony (Sb), arsenic (As), bismuth (Bi), phosphorus (P), fluorine (F), niobium (Nb), vanadium (V), tantalum (Ta), and tungsten (W). Examples of the p-type dopant include aluminum (Al), gallium (Ga), and indium (In). In the present invention, the laminated structure obtained in this manner is also included in the scope of the present invention.

The laminated structure is used in, for example, a semiconductor device by using known means either as-is or after being subjected to known processing means such as substrate peeling. The ohmic electrode and the Schottky electrode may be single metal layers or may include two or more metal layers. Laminating means of the ohmic electrode and the Schottky electrode is not particularly limited and, for example, known means such as vapor deposition, sputtering, or mist CVD may be used. Examples of the semiconductor device include a Schottky barrier diode (SBD). In addition, the semiconductor device may be incorporated into a module, an electronic device equipped with the semiconductor device, or a component of the electronic device, is useful for a variety of applications, and is particularly preferably applied to a power device. The semiconductor device can be classified into horizontal elements (horizontal devices) in which electrodes are formed on one surface of a semiconductor layer and vertical elements (vertical devices) in which electrodes are formed on both front and back surfaces of the semiconductor layer and, in the present invention, the semiconductor device can be suitably used for both horizontal devices and vertical devices.

While an example of the semiconductor device that is suitably used in the present invention will be described below in greater detail with reference to the drawings, it is to be understood that the present invention is not limited to the example. The following is a suitable example of using a single crystal film according to the present invention as a semiconductor layer.

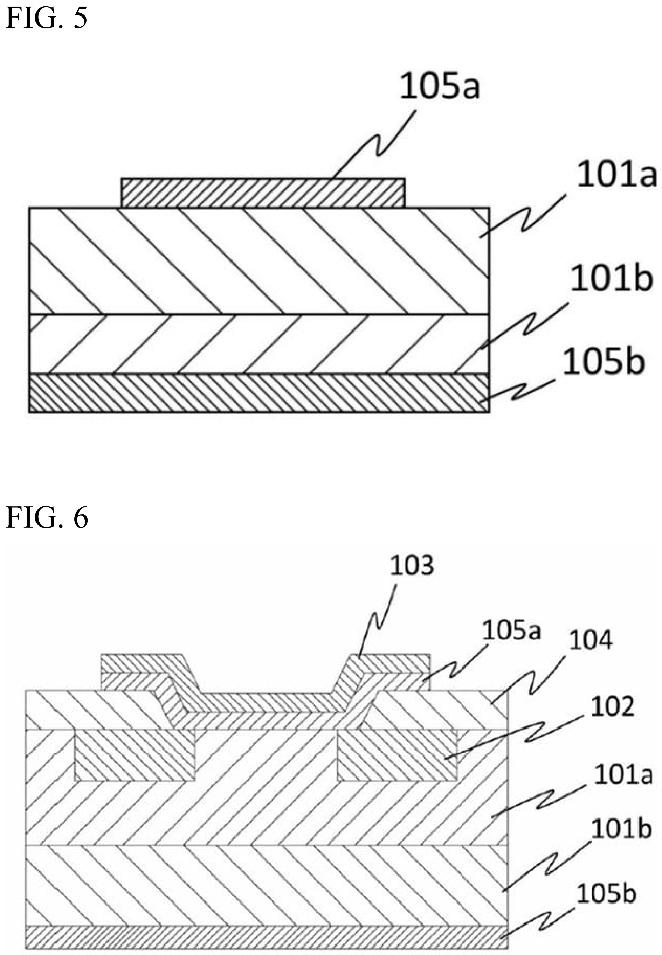

When a reverse bias is applied to the SBD shown in FIG. 5, a depletion layer (not illustrated) spreads into the n-type semiconductor layer 101a, resulting in a high-breakdown voltage SBD. In addition, when a forward bias is applied, electrons flow from the ohmic electrode 105b to the Schottky electrode 105a. The SBD using the laminated structure in this manner excels for high-breakdown voltage and high current applications, exhibits excellent Schottky characteristics, features fast switching speeds, and demonstrates superior voltage withstand capability and reliability.

FIG. 6 shows a suitable example of a Schottky barrier diode (SBD) including an n⁻semiconductor layer 101a, an n⁺ semiconductor layer 101b, a p-type semiconductor layer 102, a metal layer 103, an insulator layer 104, a Schottky electrode 105a, and an ohmic electrode 105b. Note that the metal layer 103 is comprising a metal such as Al and covers the Schottky electrode 105a.

While examples of materials for the insulator layer 104 include GaO, AlGaO, InAlGaO, AlInZnGaO₄, AlN, Hf₂O₃, SiN, SiON, Al₂O₃, MgO, GdO, SiO₂, and Si₃N₄, in the present invention, the material preferably has a corundum structure. Using an insulator having a corundum structure in the insulator layer enables functional characteristics of semiconductors to be favorably manifested at the interface. The insulator layer 104 is provided between the n⁻ semiconductor layer 101 and the Schottky electrode 105a. For example, the insulator layer can be formed using known means such as sputtering, vapor deposition, or CVD.

Other configurations and the like are similar to those of the SBD shown in FIG. 5 described above.

The SBD in FIG. 6 exhibits superior insulation characteristics compared to the SBD in FIG. 5 and has higher current control capability.

### (MESFET)

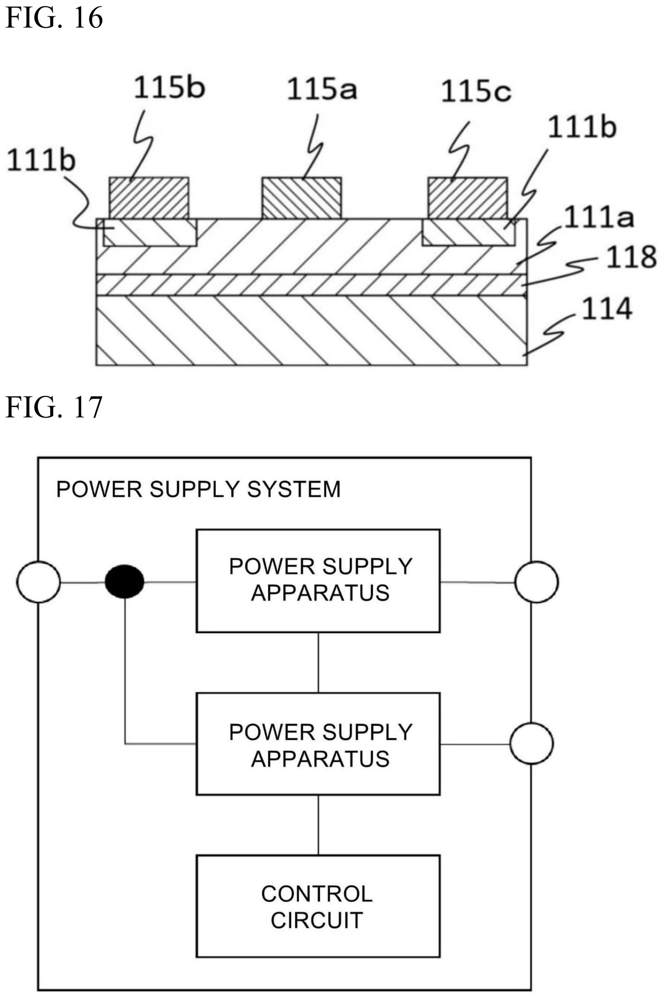

FIG. 16 shows an example of a metal-semiconductor field-effect transistor (MESFET) used in the present invention. The MESFET shown in FIG. 16 includes an n⁻ semiconductor layer 111a, an n⁺ semiconductor layer 111b, a buffer layer 118, a semi-insulator layer 114, a gate electrode 115a, a source electrode 115b, and a drain electrode 115c.

The gate electrode preferably has Schottky characteristics and, in the present invention, the Schottky electrode described earlier can be suitably used as the gate electrode. In addition, the drain electrode preferably has ohmic characteristics and the ohmic electrode described earlier can be suitably used as the drain electrode.

In the MESFET shown in FIG. 16, since a high-quality depletion layer is formed beneath the gate electrode, a current flowing from the drain electrode to the source electrode can be efficiently controlled.

### (Semiconductor system)

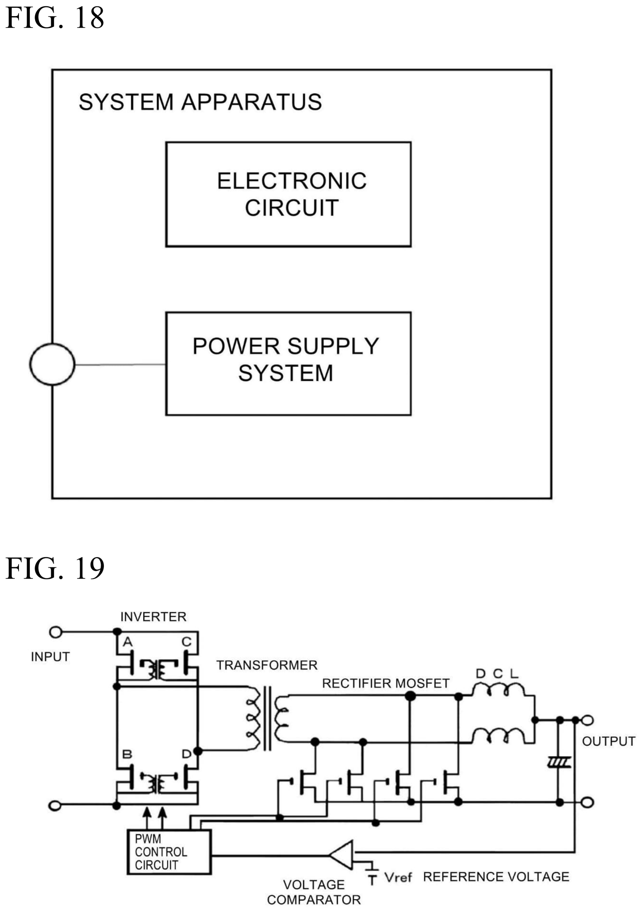

The semiconductor device described above is used in a semiconductor system such as a system using a power supply apparatus. The power supply apparatus can be fabricated by connecting the semiconductor device to wiring patterns and the like using known means. FIG. 17 shows an example of a power supply system. In the example shown in FIG. 17, the power supply system is constructed using a plurality of the power supply apparatuses and a control circuit. As shown in FIG. 18, the power supply system can be used in a system apparatus in combination with an electronic circuit. FIG. 19 shows an example of a power supply circuit diagram of the power supply apparatus. FIG. 19 shows a power supply circuit of a power supply apparatus constituted of a power circuit and a control circuit. The power supply circuit uses an inverter (constituted of MOSFETs A to D) to switch a DC voltage at high frequency and convert the DC voltage into AC voltage, implements insulation and voltage transformation using a transformer, and after rectification by rectifier MOSFETs (A and B), performs smoothing using a DCL (smoothing coils L1 and L2) and capacitors, and outputs a DC voltage. At this point, a voltage comparator compares the output voltage to a reference voltage and controls the inverter and rectifier MOSFETs via the PWM control circuit to achieve a desired output voltage.

### [Examples]

### (Example 1)

### 1. Formation of n⁺ semiconductor layer

### 1-1. Film deposition apparatus

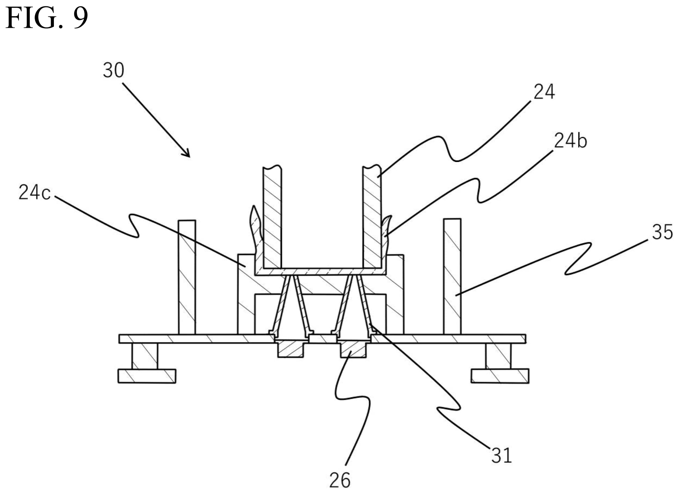

FIG. 1 is a diagram showing an example of a suitable aspect of the film deposition apparatus according to the present invention. A film deposition apparatus 19 is including a sample to be coated 20, a sample stage 21, a carrier gas source 22a, a dilution gas source 22b, a flow rate control valve 23a, a flow rate control valve 23b, a film deposition chamber 27, a heater 28, and an atomization apparatus 30. The atomization apparatus 30 is including a raw material barrier 24, an atomization raw material solution 24a, an ultrasonic transmission substrate 24b, a base 24c, an ultrasonic transducer 26, a guide barrier 31, an ultrasonic transmission liquid tank 35, and an ultrasonic transmission liquid 36.
In addition, FIG. 2 is a diagram showing an example of another suitable aspect of the film deposition apparatus when the atomization apparatus according to the present invention is used as a film deposition atomization stand. The atomization apparatus 30 is including the raw material barrier 24, the atomization raw material solution 24a, the ultrasonic transmission substrate 24b, the base 24c, the ultrasonic transducer 26, the guide barrier 31, the ultrasonic transmission liquid tank 35, and the ultrasonic transmission liquid 36. The sample stage 21 is made of quartz and a surface on which the sample to be coated 20 is mounted is inclined with respect to a horizontal plane. Fabricating both the film deposition chamber 27 and the sample stage 21 out of quartz prevents impurities derived from the apparatus from being mixed into a crystal film formed on the sample to be coated 20. The atomization raw material solution 24a was placed inside the raw material barrier 24. The guide barrier 31 is in contact with the ultrasonic transmission substrate 24b. FIG. 9 is a diagram schematically showing a sectional view from the side of the atomization apparatus used in the present invention.
The atomization apparatus 30 shown in FIG. 9 includes the raw material barrier 24, the ultrasonic transmission substrate 24b, the base 24c, the ultrasonic transducer 26, the guide barrier 31, and the ultrasonic transmission liquid tank 35. The guide barrier 31 is in contact with the ultrasonic transmission liquid tank 35. Here, the ultrasonic transducer is enclosed by the guide barrier all the way to the ultrasonic transmission substrate, and due to the use of the guide barrier 31, ultrasonic waves emitted from the ultrasonic transducer 26 are transmitted more efficiently to the raw material barrier 24.

The ultrasonic transducer is not particularly limited as long as the ultrasonic transducer is an element capable of generating ultrasonic vibrations and irradiating a bottom surface portion of the raw material barrier with ultrasonic waves, and may be known ultrasonic transducers. While a frequency of the ultrasonic transducer is not particularly limited as long as it does not hinder the object of the present invention, the frequency is preferably 2.4 MHz or higher and more preferably 3.0 MHz or higher. Examples of the ultrasonic transducer include an ultrasonic transducer configured such that electrodes are provided on both surfaces of a disc-shaped piezoelectric element, and when an oscillator is connected to the electrodes to change the oscillation frequency, ultrasonic waves are generated with a resonant frequency in a thickness direction and a resonant frequency in a radial direction of the piezoelectric vibrator. According to such a preferable range, a particle size of mist generated by atomization can be reduced and atomization efficiency can be improved.

The raw material barrier according to the present invention is not particularly limited as long as atomization raw materials can be stored therein. In the present invention, preferably, the raw material barrier is bottomless, and by having the raw material barrier and the ultrasonic transmission liquid tank fitted together or screwed together via the ultrasonic transmission substrate, a bottom surface portion of the raw material barrier is closed by the ultrasonic transmission substrate so that the raw material barrier can store an atomization raw material solution. For example, when the ultrasonic transmission substrate is a polymer film, the polymer film is sandwiched such that the bottom surface portion of the raw material barrier is closed by the ultrasonic transmission substrate and the closure enables the raw material barrier to store the atomization raw material solution. Means for fitting or screwing together the raw material barrier and the ultrasonic transmission liquid tank is not particularly limited as long as it does not hinder the object of the present invention, and known means may be used. Examples of fitting means providing recesses, protrusions, or irregular surfaces on the raw material barrier and providing corresponding fitting portions on the ultrasonic transmission liquid tank, or providing recesses, protrusions, or irregular surfaces on the ultrasonic transmission liquid tank and providing corresponding fitting portions on the raw material barrier. Examples of screwing means providing male screw portions on the raw material barrier and providing female screw portions on the ultrasonic transmission liquid tank, or providing male screw portions on the ultrasonic transmission liquid tank and providing female screw portions on the raw material barrier. In the present invention, the raw material barrier and the ultrasonic transmission liquid tank can be fitted and screwed using known members. Since the ultrasonic transmission substrate can be used more effectively, preferably, the raw material barrier and the ultrasonic transmission substrate have approximately the same cross-sectional shape and also have approximately the same cross-sectional area.

In addition, in the present invention, the raw material barrier is preferably a lidded cylindrical body with a lid. While a shape of the lid is not particularly limited as long as the lid can serve as a lid for the raw material barrier, a lid capable of sealing the space within the raw material barrier is preferable since atomization efficiency and mist controllability can be further improved. In addition, a constituent material of the lid is also not particularly limited and may be a same material as the raw material barrier or a different material from the raw material barrier. The material may be a known material, an inorganic material, or an organic material. In the present invention, the constituent material of the lid preferably contains glass, quartz, and fluororesin as main components and more preferably contains fluororesin as its main component. Examples of fluororesin include polytetrafluoroethylene, modified polytetrafluoroethylene, tetrafluoroethylene-perfluoroalkyl vinyl ether copolymer, and ethylene-tetrafluoroethylene copolymer.

In the present invention, as described above, the raw material barrier is preferably a lidded cylindrical body. When the raw material barrier has a lid, the interior of the raw material barrier can be sealed and the atomization raw material can be replenished using space pressure. More specifically, when a liquid level of the atomization raw material drops due to atomization, space pressure of the raw material barrier increases, causing the liquid level to reach a tip of piping. A space portion of the raw material barrier and a space portion of a replenishment container storing replenishment atomization raw material are communicated with each other via the piping. Via the piping, gas from the space portion in the raw material barrier can be vented into the space portion in the replenishment container and atomization raw material in the replenishment container can be replenished into the raw material barrier. Providing such replenishment means is also a preferred aspect of the present invention.

The atomization raw material is not particularly limited as long as the raw material is atomizable and may be any known atomization raw material solution including liquid dispersants such as sols. The atomization raw material may be a raw material solution containing organic compounds or a raw material solution containing inorganic compounds. In the present invention, the atomization raw material solution is preferably a raw material solution for deposition and more preferably contains a metal. While examples of the metal include one or two or more metals selected from the group consisting of gold (Au), silver (Ag), platinum (Pt), copper (Cu), iron (Fe), manganese (Mn), nickel (Ni), palladium (Pd), cobalt (Co), rhodium (Rh), ruthenium (Ru), chromium (Cr), molybdenum (Mo), germanium (Ge), titanium (Ti), tin (Sn), zirconium (Zr), vanadium (V), yttrium (Y), zinc (Zn), magnesium (Mg), scandium (Sc), hafnium (Hf), antimony (Sb), bismuth (Bi), tantalum (Ta), iridium (Ir), tungsten (W), niobium (Nb), lanthanum (La), cerium (Ce), and aluminum (Al), suitable examples of one or two or more metals selected from the group consisting of gallium, germanium, titanium, tin, niobium, vanadium, antimony, bismuth, tantalum, aluminum, and indium. In the present invention, since excellent film-forming effects can be exhibited, the atomization raw material solution is preferably a raw material solution for deposition and more preferably a raw material solution for mist CVD. In addition, the atomization raw material solution may consist of one type of raw material solution or two or more types of raw material solutions. For example, when using two or more types of raw material solutions, at least one type may be a raw material solution containing an inorganic compound and another type may be a raw material solution containing an organic compound.

The ultrasonic transmission liquid tank according to the present invention is not particularly limited as long as the ultrasonic transmission liquid can be stored therein. In addition, although the shape of the ultrasonic transmission liquid tank is also not particularly limited, in the present invention, the shape is preferably cylindrical, approximately cylindrical, polygonal tubular, or approximately polygonal tubular, more preferably cylindrical or approximately cylindrical, and most preferably cylindrical. The constituent material of the ultrasonic transmission liquid tank is also not particularly limited and may be an inorganic material or an organic material, in the present invention, the constituent material of the ultrasonic transmission liquid tank preferably contains glass, quartz, and fluororesin as main components and more preferably contains fluororesin as its main component. The ultrasonic transmission liquid is not particularly limited as long as the ultrasonic transmission liquid has a liquid form and is capable of transmitting ultrasonic waves including liquid dispersants such as sols. While examples of the ultrasonic transmission liquid include inorganic solvents and organic solvents, in the present invention, the ultrasonic transmission liquid is preferably an inorganic solvent and more preferably water. As the water, more specifically, examples include pure water, ultrapure water, tap water, well water, mineral spring water, mineral water, hot spring water, spring water, freshwater, and seawater, and water (for example, ozonated water, purified water, hot water, ion-exchanged water, physiological saline, phosphate buffer, and phosphate-buffered physiological saline) created by treating such water by processes such as purification, heating, sterilization, filtration, ion exchange, electrolysis, osmotic pressure adjustment, and buffering is also included as an example. In the present invention, the interior of the ultrasonic transmission liquid tank is preferably sealed, and forming a sealed space enables atomization efficiency and mist controllability to be further improved.

The ultrasonic transmission substrate is not particularly limited as long as it does not hinder the object of the present invention, and known ultrasonic transmission substrates may be used. Examples of the ultrasonic transmission substrate include a polymer film. While examples of the constituent material of the ultrasonic transmission substrate include thermoplastic resins and thermoset resins, in the present invention, thermoplastic resins are preferable. While examples of the thermoplastic resins include polyolefin and fluororesin, preferably, fluororesin is contained as its main component. Examples of polyolefin include polyethylene and polypropylene. Examples of fluororesin include polytetrafluoroethylene, modified polytetrafluoroethylene, tetrafluoroethylene-perfluoroalkyl vinyl ether copolymer, and ethylene-tetrafluoroethylene copolymer. In the present invention, the fluororesin is preferably at least one selected from the group consisting of polytetrafluoroethylene, modified polytetrafluoroethylene, tetrafluoroethylene-perfluoroalkyl vinyl ether copolymer, and ethylene-tetrafluoroethylene copolymer. According to such a preferable range, ultrasonic waves enable efficient transmission of atomization raw materials and an atomization volume can be further increased.

The constituent material of the guide barrier is not particularly limited as long as it does not hinder the object of the present invention and examples of the constituent material include metals and high polymers. In addition, examples of the high polymers include natural resins, thermoplastic resins, and thermoset resins. Furthermore, a surface of the guide barrier may be coated with a metal. Examples of the metal include Al, Cu, Ag, Ti, W, Mo, Fe, Ni, Cr, Zn, Sn, Rh, Pt, and Au. According to such a preferable range, ultrasonic vibrations can be transmitted more efficiently and effectively. Although the shape of the guide barrier is not particularly limited as long as it does not hinder the object of the present invention, in the present invention, the shape is preferably cylindrical, approximately cylindrical, polygonal tubular, or approximately polygonal tubular, a shape of a truncated cone is also preferable, the shape is more preferably a truncated cone or approximately cylindrical, and the shape is most preferably a truncated cone. In addition, the guide barrier is not particularly limited as long as it does not hinder the object of the present invention and the guide barrier is preferably penetrable. According to such a preferable range, ultrasonic waves emitted by the ultrasonic transducer can be transmitted to the ultrasonic transmission substrate more efficiently and effectively. The guide barrier is not particularly limited as long as it does not hinder the object of the present invention, and while the guide barrier may be configured to be attachable and detachable or installed on an ultrasonic radiation surface, the guide barrier is preferably configured to be attachable and detachable in the present invention. According to such a preferable range, the atomization apparatus according to the present invention can be more readily cleaned.

### 1-2. Fabrication of atomization raw material solution

When preparing the atomization raw material solution, the concentration in the atomization raw material solution was adjusted to 0.02 M bis-carboxy-germanium sesquioxide. During the adjustment, hydrogen chloride was added at a volume ratio of 10% to create the atomization raw material solution. In addition, the concentration of antimony chloride to be used as an n-type dopant was adjusted to 3 mol% relative to the concentration of bis-carboxy-germanium sesquioxide in the atomization raw material solution.

### 1-3. Preparation of film deposition

Next, the atomization raw material solution 24a obtained in "1-2. Fabrication of atomization raw material solution" described above was placed in the raw material barrier 24. As the sample to be coated 20, a TiO₂ (001) substrate having a rutile crystal structure with a GeO₂ crystal film having a rutile crystal structure, a 17 mm by 17 mm square shape, and an average thickness of 500 µm was placed on the sample stage 21, and the heater 28 was activated to raise the temperature in the film deposition chamber 27 to 700°C. Next, the flow rate control valve 23 was opened to supply carrier gas from the carrier gas source 22a into the film deposition chamber 27, and after the atmosphere in the film deposition chamber 27 was sufficiently replaced with the carrier gas, the flow rate of the carrier gas was adjusted to 1 L/min. Nitrogen gas was used as the carrier gas. The TiO₂ (001) substrate having a rutile crystal structure with the GeO₂ crystal film having a rutile crystal structure was obtained by depositing a GeO₂ crystal film having a rutile crystal structure on a TiO₂ (001) substrate having a rutile crystal structure in the same manner as described above, except that antimony chloride, which is used as an n-type dopant, was not used.

### 1-4. Formation of oxide semiconductor crystal film

Next, the ultrasonic transducer 26 was vibrated at 3.0 MHz, and the vibration thereof was transmitted to the atomization raw material solution 24a through an ultrasonic transmission body 25a to atomize the atomization raw material solution 24a and generate raw material fine particles. The raw material fine particles were introduced into the film deposition chamber 27 by the carrier gas, reacted within the film deposition chamber 27, and formed a tetragonal GeO₂ crystal film on the sample to be coated 20 due to a CVD reaction on a film deposition surface of the sample to be coated 20. Note that the film thickness was 500 nm.

### 1-5. Evaluation

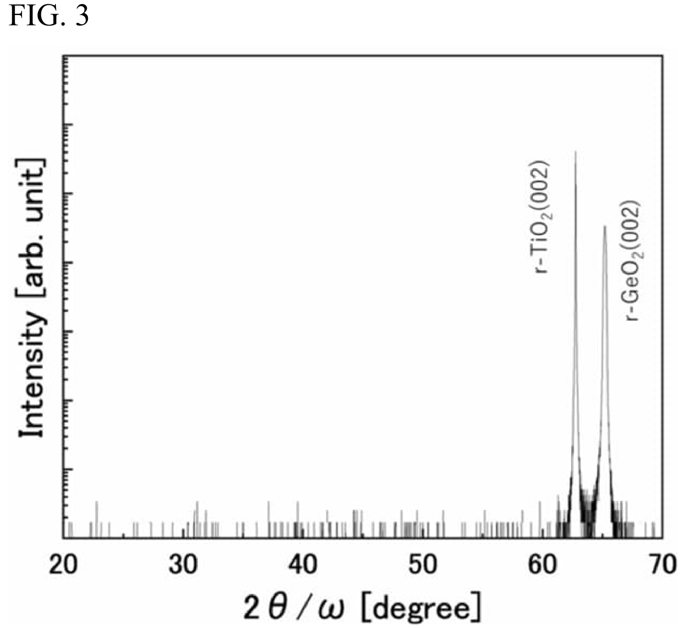

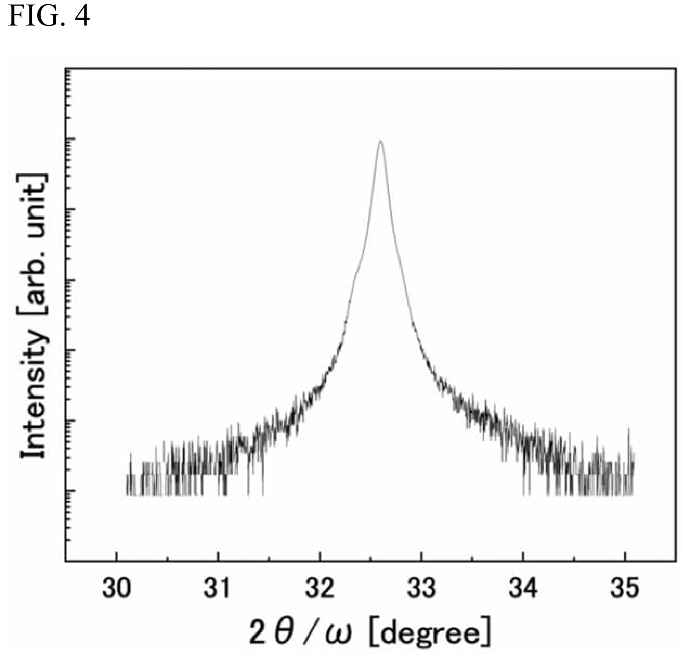

The GeO₂ crystal film obtained in "1-4. Formation of oxide semiconductor crystal film" described above was measured using an X-ray diffractometer. FIG. 3 is a diagram showing a result of 2θ/ω in an XRD diffraction result. As is apparent from FIG. 3, the obtained crystal film was a GeO₂ single crystal film having a tetragonal rutile structure with a (002) orientation. In addition, a result of an ω scan in X-ray diffraction measurement is shown in FIG. 4. As shown in FIG. 4, a half-width of a rocking curve at a (002) diffraction peak of r-GeO₂ was 350 arcsec. These results indicate that a GeO₂ crystal film having favorable crystallinity was formed as an n⁺ semiconductor layer on a TiO₂ (001) substrate with a rutile crystal structure.

In addition, the electrical characteristics of the obtained film were evaluated by measuring the Hall effect using the van der Pauw method. The measurement environment was set at room temperature with an applied magnetic field frequency of 50 MHz. As a result, the carrier density was 9.28 × 10¹⁹ (1/cm³), and the mobility was 24 (cm²/V·s). In addition, the sheet resistance was 4.6 × 10¹ (Ω/□). The electrical resistivity was 2.76 × 10⁻³ Ωcm. Furthermore, the carrier type was "n". Based on these results, the obtained GeO₂ crystal film exhibited favorable electrical characteristics as an n⁺ semiconductor layer.

### 2. Formation of n⁻ semiconductor layer

A semiconductor layer was formed in a similar manner to "1. Formation of n⁺ semiconductor layer" described above with the exception of not adding antimony chloride to the atomization raw material solution and using the TiO₂ (001) substrate with an n⁺ GeO₂ crystal film obtained in "1. Formation of n⁺ semiconductor layer" described above as the substrate.

### 2-1. Evaluation

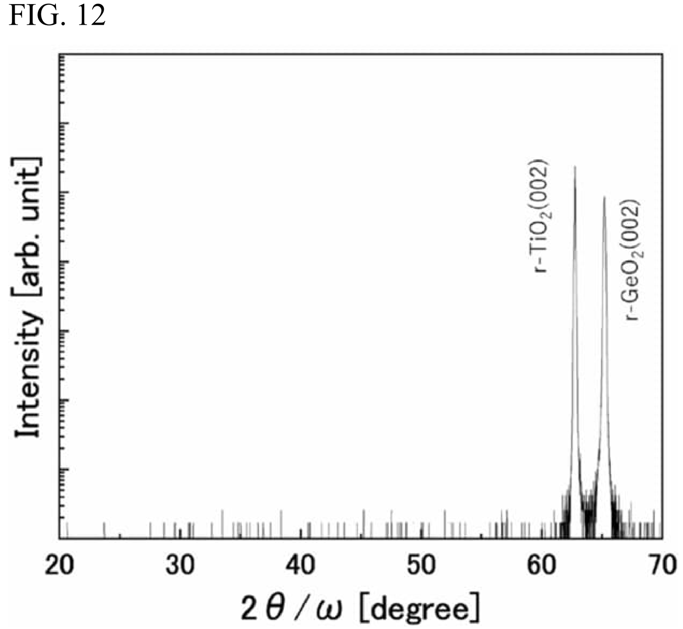

A crystal film of the formed semiconductor layer was measured using an X-ray diffractometer. FIG. 12 shows a result of 2θ/ω in an XRD diffraction result. As is apparent from FIG. 12, the obtained crystal film was a GeO₂ single crystal film having a tetragonal rutile structure with a (002) orientation. A GeO₂ crystal film having favorable crystallinity was formed on a TiO₂ (001) substrate with a rutile crystal structure. In addition, the film thickness of the obtained n⁻ semiconductor layer was 1.00 µm.

### 3. Formation of electrodes

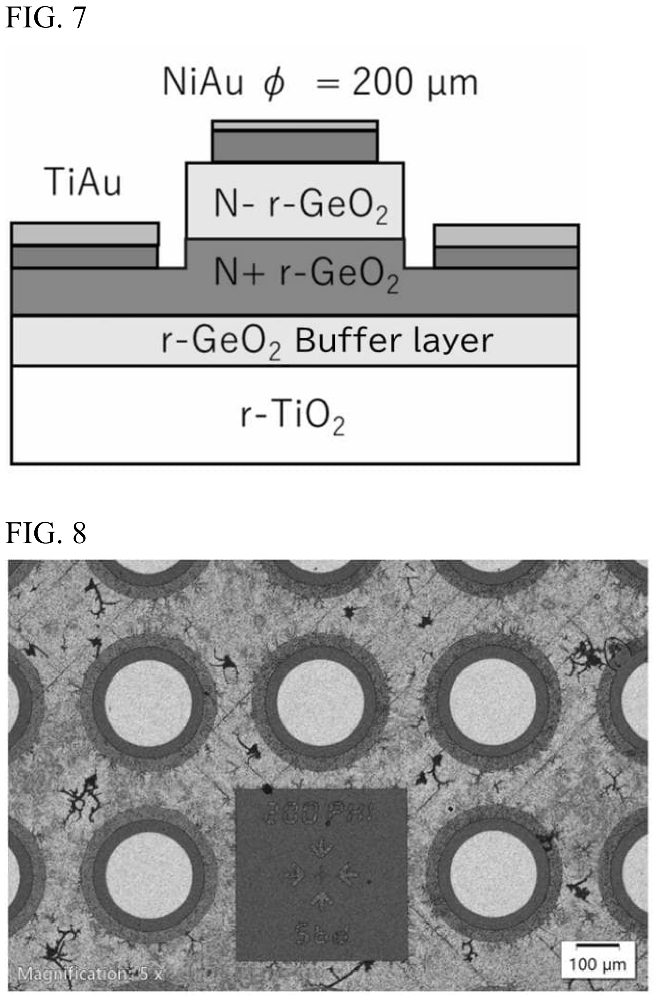

An SBD having a pseudo-vertical structure shown in FIG. 7 was fabricated using photolithography and dry etching. The electrodes were formed by EB vapor deposition. Electrode formation conditions are listed below. Note that FIG. 8 is a diagram showing a surface image of a sample in which an electrode is formed on a crystal film.

### (Formation condition of ohmic electrode)

### Lithography

HMDS 5000 rpm 20 s
LOR5A 5000 rpm 60 s, 180°C 5 min
AZ5214E 5000 rpm 60 s, 110°C 1 min
DWL 66+ 10 mm, Int 50%, Filter 100%
TMAH 2.38 wt%, 2 min

### Rinse

Descum UV Ozone 2 min
EB Deposition
Ti 75 nm, 0.2 nm/s
Au 75 nm, 0.2 nm/s
Lift-off NMP 80°C 30 min, IPA, IPA, Rinse
RTA N2 0.5 slm, 550°C, 60 s
(Formation condition of Schottky electrode)

### Lithography

HMDS 5000 rpm 20 s
LOR5A 5000 rpm 60 s, 180°C 5 min
AZ5214E 5000 rpm 60 s, 110°C 1 min
DWL 66+ 10 mm, Int 50%, Filter 100%
TMAH 2.38 wt%, 2 min

### Rinse

UV Ozone ashing, 2 min
EB Deposition
Ni 100 nm, 0.2 nm/s
Au 50 nm, 0.2 nm/s
Lift-off NMP 80°C 30 min, IPA, IPA, Rinse

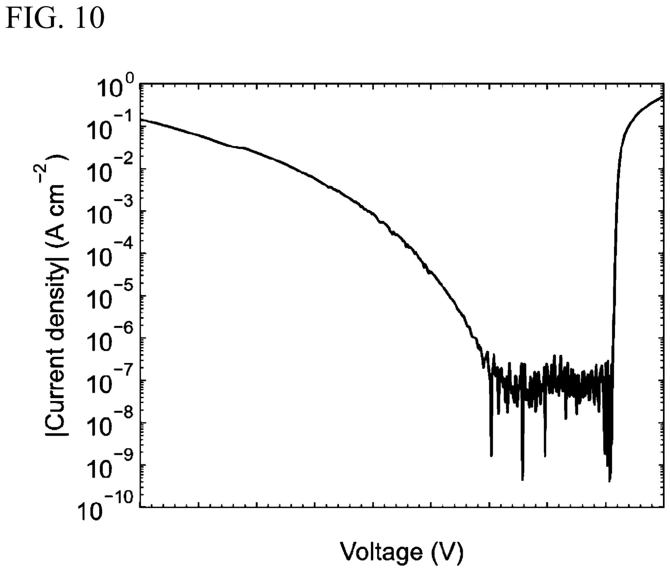

An IV measurement was performed with respect to the SBD having the pseudo-vertical structure obtained as described above. Results are shown in FIG. 10. From FIG. 10, the Schottky characteristics can be confirmed to be favorable. These results demonstrate that Example 1 has superior semiconductor characteristics and Schottky characteristics.

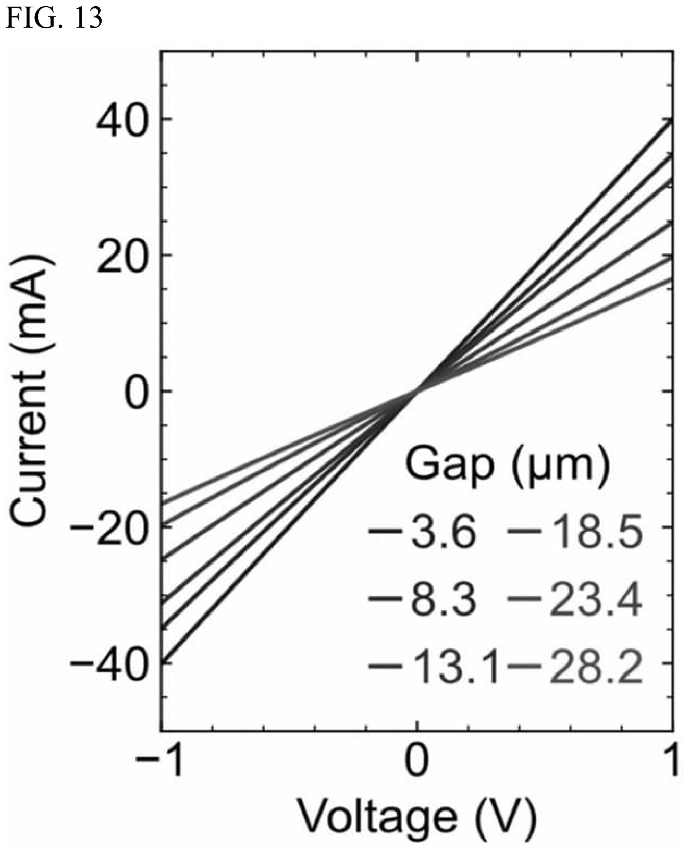

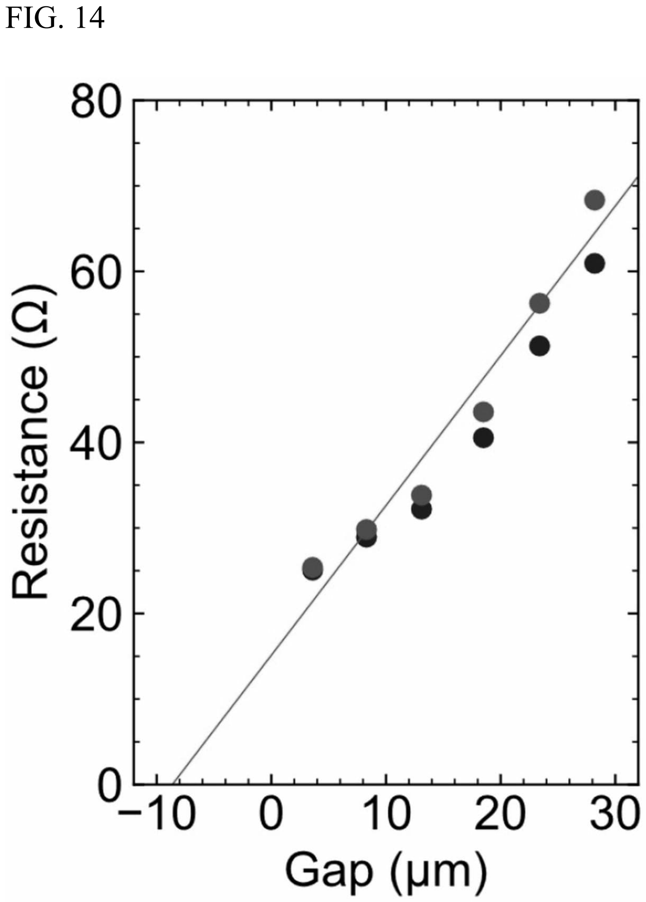

In addition, the ohmic characteristics of an SBD with the obtained pseudo-vertical structure were implemented by an IV measurement. Results are shown in FIG. 13. From FIG. 13, the formation of ohmic contacts was confirmed. In addition, a TLM measurement was performed with respect to the SBD with the obtained pseudo-vertical structure and the contact resistance was found to be 6.6 × 10⁻⁵ Ωcm². Results of the TLM measurement are shown in FIG. 14. These results show that more favorable contact resistance is achieved. Therefore, the present invented article has a contact resistance of 10 × 10⁻⁵ Ωcm² or lower and is extremely superior in terms of electrical characteristics.

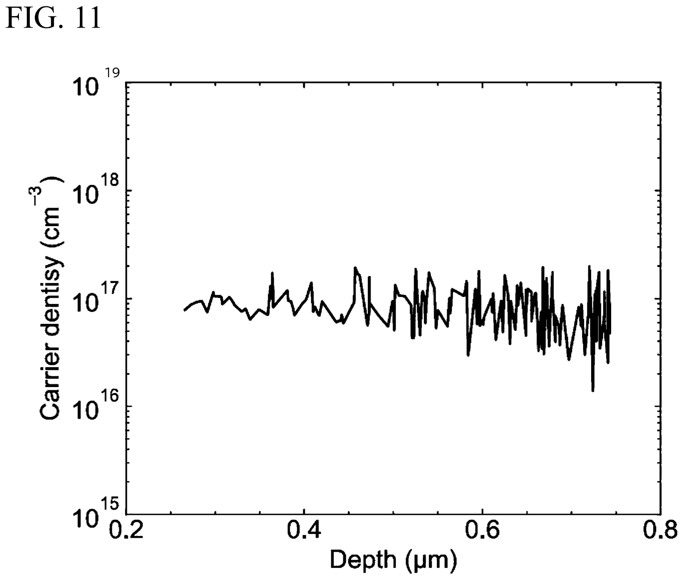

Furthermore, a CV measurement was performed with respect to the n⁻ semiconductor layer of the SBD having the obtained pseudo-vertical structure and the carrier concentration was calculated from a result of the CV measurement. In Example 1, the carrier concentration was within a range of 1 × 10⁻¹⁶ to 3 × 10⁻¹⁷ cm⁻³. This demonstrates that the carrier concentration can be readily controlled in the present invention. Note that a relationship between the carrier concentration calculated from a result of the CV measurement according to Example 1 and depth is shown in FIG. 11.

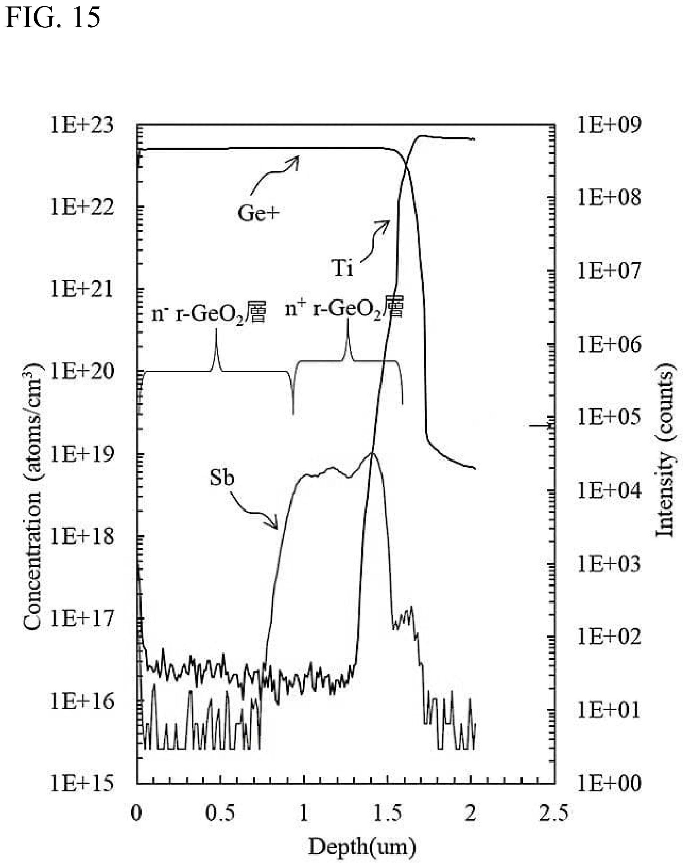

Furthermore, secondary ion mass spectrometry (SIMS) was performed with respect to the SBD having the obtained pseudo-vertical structure to analyze the impurity concentrations contained in the r-GeO₂ thin film. Results are shown in FIG. 15. FIG. 15 shows that the n⁻layer r-GeO₂ thin film contains approximately 2.6 × 10¹⁵ atoms/cm³ of Sb. FIG. 15 also shows that the n⁺ layer r-GeO₂ thin film contains approximately 5.76 × 10¹⁸ atoms/cm³ of Sb. From the above, it can be seen that in the present invention, the n⁻ layer contains approximately 2.6 × 10¹⁵ atoms/cm³ of Sb, and the n⁺ layer r-GeO₂ thin film contains approximately 1 × 10¹⁵ atoms/cm³ of Sb.

The semiconductor device, the electronic device, and the system according to the present invention are suitably used in, for example, a power device or the like.

### Reference Signs List

- 19: film deposition apparatus

- 20: sample to be coated
- 21: sample stage
- 22a: carrier gas source
- 22b: dilution gas source
- 23a: flow rate control valve
- 23b: flow rate control valve
- 24: raw material barrier
- 24a: atomization raw material solution
- 24b: ultrasonic transmission substrate
- 24c: base
- 26: ultrasonic transducer
- 27: film deposition chamber
- 28: heater
- 30: atomization apparatus
- 31: guide barrier
- 33: dilution gas supply pipe
- 34: carrier gas supply pipe
- 35: ultrasonic transmission liquid tank
- 36: ultrasonic transmission liquid
- 37: film deposition chamber
- 101a: n⁻ semiconductor layer
- 101b: n⁺ semiconductor layer
- 102: p-type semiconductor layer
- 103: metal layer
- 104: insulator layer
- 105a: Schottky electrode
- 105b: ohmic electrode

## Claims

1. A semiconductor device comprising a laminated structure in which a second semiconductor layer having a same crystal structure as a first semiconductor layer comprising-a crystalline oxide containing germanium or a mixed crystal of germanium as a main component is laminated directly or via another layer on the first semiconductor layer, the semiconductor device further comprising
a Schottky electrode forming a Schottky junction with the second semiconductor layer and an ohmic electrode forming an ohmic junction with the first semiconductor layer.

2. The semiconductor device according to claim 1, wherein the second semiconductor layer is comprising-a crystalline oxide containing germanium or a mixed crystal of germanium as a main component.

3. The semiconductor device according to claim 1 or 2, wherein the first semiconductor layer has a rutile structure.

4. The semiconductor device according to one of claims 1 to 3, wherein the first semiconductor layer contains a dopant.

5. The semiconductor device according to claim 4, wherein the dopant contains an element from Group 15 of the periodic table.

6. The semiconductor device according to one of claims 1 to 5, wherein the crystalline oxide contains germanium dioxide as a main component.

7. The semiconductor device according to one of claims 1 to 6, wherein a film thickness of the first semiconductor layer is 500 nm or more.

8. The semiconductor device according to one of claims 1 to 7, wherein a film thickness of the second semiconductor layer is 1.0 µm or more.

9. The semiconductor device according to one of claims 1 to 8, wherein an area of the first semiconductor layer is 100 mm² or more.

10. The semiconductor device according to one of claims 1 to 9, wherein a carrier concentration of the first semiconductor layer is 1 × 10¹⁹/cm³ or higher.

11. The semiconductor device according to one of claims 1 to 10, wherein a carrier concentration of the second semiconductor layer is 1 × 10¹⁸/cm³ or lower.

12. The semiconductor device according to one of claims 1 to 11, wherein the ohmic electrode contains one or two metallic elements selected from Groups 4 to 13 of the periodic table.

13. The semiconductor device according to one of claims 1 to 12, wherein the Schottky electrode contains one or two metallic elements selected from Groups 4 to 13 of the periodic table.

14. The semiconductor device according to one of claims 1 to 13, which is a power device.

15. The semiconductor device according to one of claims 1 to 14, which is a Schottky barrier diode (SBD).

16. An electronic device comprising a semiconductor device, wherein the semiconductor device is the semiconductor device according to one of claims 1 to 15.

17. A system comprising an electronic device, wherein the electronic device is the electronic device according to claim 16.
